# EUROPEAN PATENT APPLICATION

(11) **EP 2 565 946 A1**
(43) Date of publication of application: **06.03.2013**
(21) Application number: 11774674.3
(22) Date of filing: 10.02.2011
(51) Int. Cl.: H01L 33/44

(54) **SEMICONDUCTOR LIGHT-EMITTING ELEMENT, PROTECTIVE FILM OF SEMICONDUCTOR LIGHT-EMITTING ELEMENT, AND METHOD FOR FABRICATING SAME**

(30) Priority: 28.04.2010 JP 2010104443
(71) Applicant: Mitsubishi Heavy Industries, Ltd., Tokyo 108-8215 (JP)
(72) Inventor: KAFUKU Hidetaka, Tokyo 108-8215 (JP); NISHIMORI Toshihiko, Tokyo 108-8215 (JP); KAWASAKI Hisao, Tokyo 108-8215 (JP)
(74) Representative: HOFFMANN EITLE
(86) International application number: PCT/JP2011/052814
(87) International publication number: WO 2011/135889

(57) **Abstract**

Disclosed are: a semiconductor light-emitting element that fulfills all of having high migration prevention, high transmittance, and low film-production cost; the protective film of the semiconductor light-emitting element; and a method for fabricating same. To this end, in the semiconductor light-emitting element-which has: a plurality of semiconductor layers (12-14) formed on a substrate (11); and electrode sections (15, 16) and other electrode sections (17, 18) that are the electrodes of the plurality of semiconductor layers (12-14)-as the protective film thereof, the surroundings of the plurality of semiconductor layers (12-14), the electrode sections (15, 16), and the other electrode sections (17, 18) are covered by a SiN film (21) comprising silicon nitride of which the quantity of Si-H bonds in the film is less than 1.0×10²¹ bonds/cm³.

## Description

### TECHNICAL FIELD

The present invention relates to a semiconductor light-emitting element, a protective film of the semiconductor light-emitting element, and a method for fabricating the protective film.

### BACKGROUND ART

As semiconductor light-emitting elements, white LEDs (Light Emitting Diodes) capable of achieving energy saving and a long life are being expected as new indoor and outdoor illumination materials.
Patent Document 1: Japanese Patent Application Publication No. 2006-041403
Patent Document 2: Japanese Patent Application Publication No. 2007-189097

### DISCLOSURE OF THE INVENTION

### PROBLEM TO BE SOLVED BY THE INVENTION

At present, white LEDs capable of achieving both energy saving and a long life are limited to those of a power-saving type. Thus, to replace existing illuminations with such white LEDs while taking advantage of their low energy consumption and long life, multiple low-output LED chips must be used. This has been a cause of increase in cost.

To reduce the number of LED chips used in the illumination, the light output per chip needs to be increased. However, introducing a high power to the element accelerates the migration of Ag used in electrode portions thereof. This increases the likelihood of the occurrence of a short circuit and thus lowers the reliability of the element. Thus, it is necessary to suppress the migration of Ag in order for a high-output element to be reliable.

The migration of Ag accelerates upon its reaction with moisture. Hence, using a protective film which protects Ag from moisture for an LED element can suppress the migration and is therefore effective in improving the reliability of a high-output element. Meanwhile, this protective film is required to have high light transmittance so that light generated inside the element can be taken out effectively to the outside of the element.

Now, as Conventional Example 1, an LED element structure of Patent Document 1 is shown in Fig. 8, and a problem thereof will be described. Note that in Fig. 8, reference numeral 61 denotes a substrate; 62, an n-type semiconductor layer; 63, an active layer; 64, a p-type semiconductor layer; 65, a p-electrode; 66, a p-pad; 67, an n-electrode; 68, an n-pad; 71, a SiN film; and 72, a SiO film. The p-electrode 65 has a multilayer structure of Ag/Ni/Pt. Moreover, the arrows in the drawing show how light is transmitted.

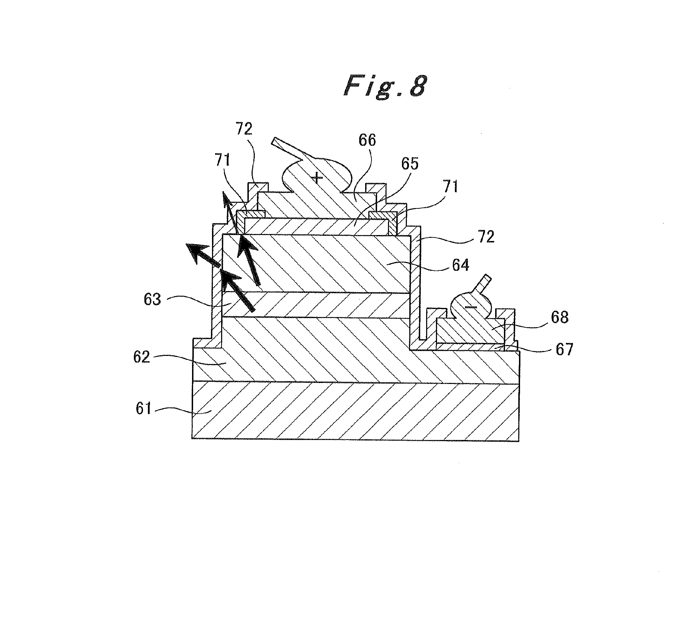

In the conventional LED element structure shown in Fig. 8, as a protective film, the SiN film 71 with high moisture resistance is used only around the p-electrode 65 and the SiO film 72 is then formed over the whole area. In this element structure, since the SiN film 71 is to be formed only around the p-electrode 65, it is necessary to perform a process of partially removing the SiN film 71 which is formed over the whole area, before the film formation of the SiO film 72. This increases the film formation cost. Moreover, in a case where Ag in the p-electrode 65 is diffused to lateral surfaces of the semiconductors, migration is likely to progress because the SiO film 72 is low in moisture resistance. Additionally, in general, since the SiN film 71 is lower in light transmittance than the SiO film 72, the transmittance drops around the p-electrode 65, hence lowering the efficiency of light extraction to the outside.

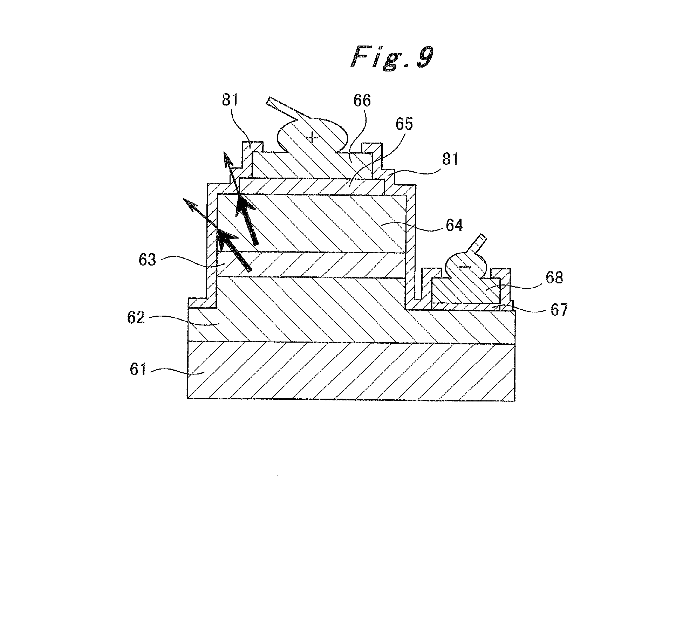

Next, as Conventional Example 2, an LED element structure of Patent Document 2 is shown in Fig. 9, and the problem thereof will be described. Note that in Fig. 9, the same components as those in Fig. 8 are denoted by the same reference numerals. Moreover, the arrows in the drawing show how light is transmitted. Note that reference numeral 81 denotes a SiN film.

In the conventional LED element structure shown in Fig. 9, the SiN film 81 with high moisture resistance is used over the whole element as a protective film. In this element structure, since the SiN film 81 with low transmittance covers the whole element, the efficiency of light extraction from the element to the outside is lowered. Additionally, in general, since the SiN film 81 has lower withstand voltage than SiO films, its film thickness needs to be large to secure its insulation performance. This increases the time required in the film formation and the cost of the film formation.

As described, in the conventional LED element structures, satisfying all of high migration prevention performance, high transmittance, and low film formation cost has been difficult, thus causing a problem in implementing a high-luminance structure.

The present invention has been made in view of the above problem, and an object thereof is to provide a semiconductor light-emitting element, a protective film of the semiconductor light-emitting element, and a method for fabricating the protective film, which satisfy all of high migration prevention performance, high transmittance, and low film formation cost.

### MEANS FOR SOLVING THE PROBLEMS

A protective film of a semiconductor light-emitting element according to a first aspect for solving the above-described problem is a protective film for protecting a semiconductor light-emitting element including a plurality of semiconductor layers formed on a substrate and a plurality of electrode portions serving as electrodes of the plurality of semiconductor layers, comprising: a first protective film covering a periphery of the plurality of semiconductor layers and a periphery of the plurality of electrode portions as the protective film, wherein the first protective film is made of a silicon nitride whose number of Si-H bonds inside the film is below 1.0×10²¹ [bonds/cm³].

A protective film of a semiconductor light-emitting element according to a second aspect for solving the above-described problem is the protective film of a semiconductor light-emitting element according to the first aspect, further comprising: a second protective film covering a periphery of the first protective film, wherein the first protective film has a film thickness of 10 nm or larger, and the second protective film is made of a silicon oxide.

A protective film of a semiconductor light-emitting element according to a third aspect for solving the above-described problem is the protective film of a semiconductor light-emitting element according to the second aspect, further comprising: a third protective film covering a periphery of the second protective film, wherein the third protective film is made of a silicon nitride, whose number of Si-H bonds inside the film is below 1.0×10²¹ [bonds/cm³], and has a film thickness of 10 nm or larger as in a case of the first protective film.

A protective film of a semiconductor light-emitting element according to a fourth aspect for solving the above-described problem is the protective film of a semiconductor light-emitting element according to the third aspect, wherein the second protective film is made of a silicon oxide whose number of Si-OH bonds inside the film is 1.3×10²¹ [bonds/cm³] or smaller, in which case the film thickness of the first protective film is set to 5 nm or larger.

A protective film of a semiconductor light-emitting element according to a fifth aspect for solving the above-described problem is the protective film of a semiconductor light-emitting element according to any one of the first to fourth aspects, wherein at least one of the plurality of electrode portions is made of a metal containing silver.

A semiconductor light-emitting element according to a sixth aspect for solving the above-described problem uses the protective film of a semiconductor light-emitting element according to any one of the first to fifth aspects.

A method for fabricating a protective film of a semiconductor light-emitting element according to a seventh aspect for solving the above-described problem is a method for fabricating a protective film for protecting a semiconductor light-emitting element including a plurality of semiconductor layers formed on a substrate and a plurality of electrode portions serving as electrodes of the plurality of semiconductor layers, comprising: providing a first protective film covering a periphery of the plurality of semiconductor layers and a periphery of the plurality of electrode portions as the protective film, the first protective film being formed from a silicon nitride whose number of Si-H bonds inside the film is below 1.0×10²¹ [bonds/cm³].

A method for fabricating a protective film of a semiconductor light-emitting element according to an eighth aspect for solving the above-described problem is the method for fabricating a protective film of a semiconductor light-emitting element according to the seventh aspect, wherein a film thickness of the first protective film is set to 10 nm or larger, the method further comprises providing a second protective film covering a periphery of the first protective film, the second protective film being formed from a silicon oxide.

A method for fabricating a protective film of a semiconductor light-emitting element according to a ninth aspect for solving the above-described problem is the method for fabricating a protective film of a semiconductor light-emitting element according to the eighth aspect, further comprising: providing a third protective film covering a periphery of the second protective film , the third protective film being formed from a silicon nitride, whose number of Si-H bonds inside the film is below 1.0×10²¹ [bonds/cm³], to a film thickness of 10 nm or larger as in a case of the first protective film.

A method for fabricating a protective film of a semiconductor light-emitting element according to a tenth aspect for solving the above-described problem is the method for fabricating a protective film of a semiconductor light-emitting element according to the ninth aspect, wherein the second protective film is formed from a silicon oxide whose number of Si-OH bonds inside the film is 1.3×10²¹ [bonds/cm³] or smaller, in which case the film thickness of the first protective film is set to 5 nm or larger.

A method for fabricating a protective film of a semiconductor light-emitting element according to an eleventh aspect for solving the above-described problem is the method for fabricating a protective film of a semiconductor light-emitting element according to any one of the seventh to tenth aspects, wherein at least one of the plurality of electrode portions is made of a metal containing silver.

### EFFECT OF THE INVENTION

According to the present invention, the semiconductor light-emitting element can satisfy all of high migration prevention performance, high transmittance, and low film formation cost, thereby implementing a high-luminance structure.

### BRIEF DESCRIPTION OF THE DRAWINGS

[Fig. 1] Fig. 1 is a cross-sectional view showing an element structure of a semiconductor light-emitting element according to the present invention as an illustrative embodiment (Example 1).
[Fig. 2] Fig. 2 is a configuration diagram of a plasma processing apparatus for forming a SiN film of the semiconductor light-emitting element shown in Fig. 1.
[Fig. 3] Fig. 3 is a graph showing the relationship between the transmittance and the internal hydrogen content of the SiN film of the semiconductor light-emitting element shown in Fig. 1.
[Fig. 4] Fig. 4 is a cross-sectional view showing an element structure of a semiconductor light-emitting element according to the present invention as an illustrative embodiment (Example 2).
[Fig. 5] Fig. 5 is a graph showing the relationship between the moisture resistance and the film thickness of a SiN film of the semiconductor light-emitting element shown in Fig. 4 and that of a conventional SiN film.
[Fig. 6] Fig. 6 is a cross-sectional view showing an element structure of a semiconductor light-emitting element according to the present invention as another illustrative embodiment (Example 3).
[Fig. 7] Fig. 7 is a cross-sectional view showing an element structure of a semiconductor light-emitting element according to the present invention as still another illustrative embodiment (Example 4).
[Fig. 8] Fig. 8 is a cross-sectional view showing a conventional LED element structure.
[Fig. 9] Fig. 9 is a cross-sectional view showing another conventional LED element structure.

### EXPLANATION OF THE REFERENCE NUMERALS

- 11: substrate
- 12: n-type semiconductor layer
- 13: active layer
- 14: p-type semiconductor layer
- 15: p-electrode (electrode portion)
- 16: p-pad (electrode portion)
- 17: n-electrode (electrode portion)
- 18: n-pad (electrode portion)
- 21, 31, 41, 51: SiN film (first protective film)
- 32,42, 52: SiO film (second protective film)
- 43, 53: SiN film (third protective film)

### BEST MODES FOR CARRYING OUT THE INVENTION

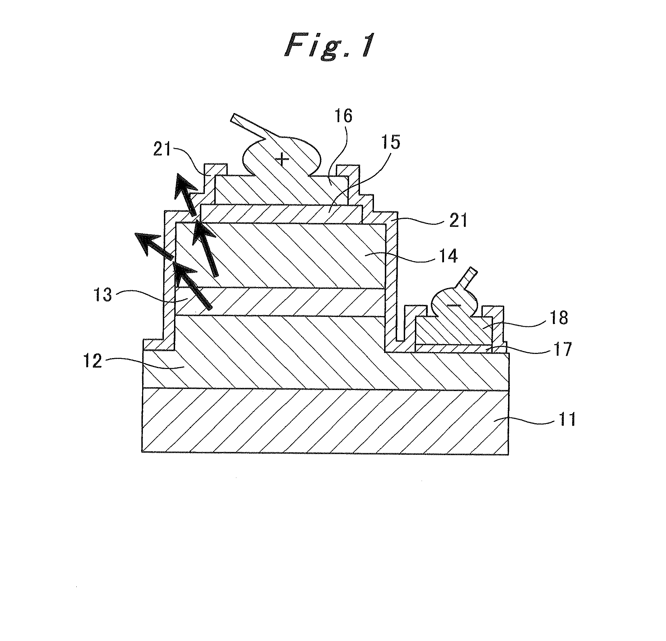

Hereinbelow, a semiconductor light-emitting element, a protective film of the semiconductor light-emitting element, and a method for fabricating the protective film according to the present invention will be described through some embodiments with reference to Figs. 1 to 7. Note that in each of examples given below, description will be given based on an instance where an LED is used as the semiconductor light-emitting element.

### (Example 1)

Fig. 1 is a cross-sectional view showing an LED element structure of this example. Moreover, the arrows in the drawings show how light is transmitted.

The LED of this example has an element structure with semiconductor layers obtained by sequentially stacking an n-type semiconductor layer 12 made of n-type GaN, an active layer 13 having a multiple quantum well structure obtained by alternately stacking GaN and InGaN, and a p-type semiconductor layer 14 made of p-type GaN, on a substrate 11 made of sapphire. Note that the n-type semiconductor layer 12 and the p-type semiconductor layer 14 have a structure including an n-type contact layer and a structure including a p-type contact layer, respectively.

Then, the p-type semiconductor layer 14, the active layer 13, and the n-type semiconductor layer 12 thus stacked are partially removed by etching to expose the n-type contact layer of the n-type semiconductor layer 12, and W and Pt are stacked on the exposed portion in this order from the semiconductor-layer side to form an n-electrode 17. On the other hand, Ag, Ni, and Pt are stacked on the upper surface of the p-type contact layer of the p-type semiconductor layer 14 in this order from the semiconductor-layer side to form a p-electrode 15. Moreover, a p-pad 16 made of Au and an n-pad 18 made of Au are formed on the p-electrode 15 and the n-electrode 17, respectively, so that bumps can be formed. As described, the pair of the p-electrode 15 and the p-pad 16 and the pair of the n-electrode 17 and the n-pad 18 serve as electrode portions for the stacked semiconductor layers, respectively.

In the element structure described above, a SiN film 21 (first protective film) is stacked in such a way as to cover the periphery of each semiconductor layer (the n-type semiconductor layer 12, the active layer 13, and the p-type semiconductor layer 14) and the periphery of each electrode portion (the pair of the p-electrode 15 and the p-pad 16 and the pair of the n-electrode 17 and the n-pad 18) except for openings on the p-pad 16 and the n-pad 18 for the bumps. This SiN film 21 is made of a SiN having insulating properties and high transmittance, and this single layer forms a protective film. Accordingly, the structure is such that the SiN film 21 protects not only the periphery of the p-electrode 15 containing Ag but also the periphery of the whole element.

As mentioned earlier, SiN protective films normally have a problem that they have high moisture resistance but have low transmittance and poor withstand voltage.

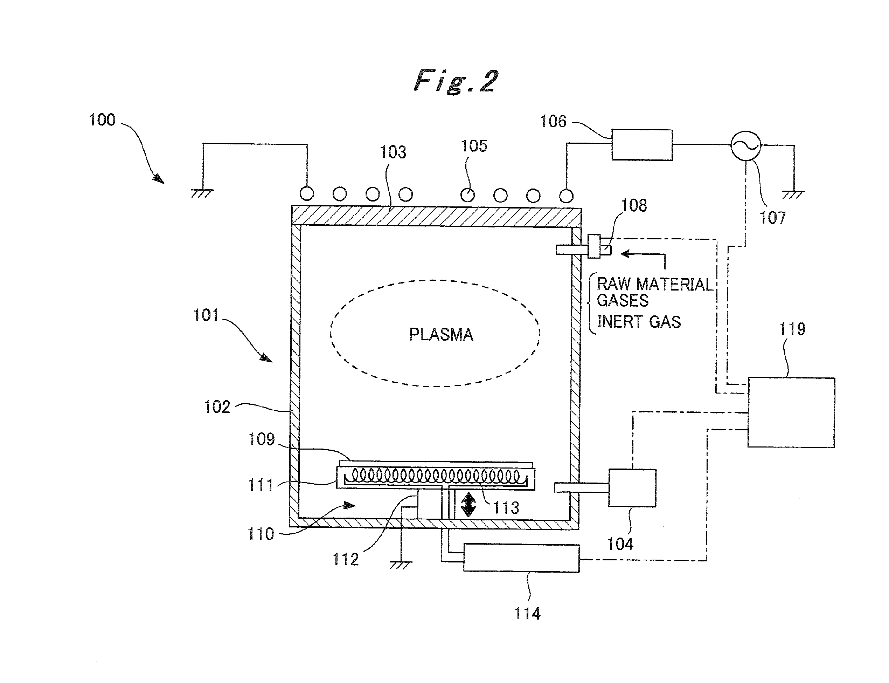

In this respect, in this example, the SiN film 21 is formed by a plasma CVD apparatus shown in Fig. 2 which uses high-density plasma. In this way, though being a SiN film, the film can have film properties which allow as high transmittance as those of SiO films.

Now, a plasma CVD apparatus 100 for forming the SiN film 21 will be described with reference to Fig. 2.

As shown in Fig. 2, the plasma CVD apparatus 100 includes a vacuum chamber 101 configured to maintain a high vacuum therein. This vacuum chamber 101 is formed of a tubular container 102 and a top panel 103, and a space tightly sealed from outside air is created by attaching the top panel 103 to an upper portion of the tubular container 102. On the vacuum chamber 101, a vacuum device 104 configured to vacuum the inside of the vacuum chamber 101 is placed.

An RF antenna 105 configured to generate plasma is placed on top of the top panel 103. An RF power source 107 being a high-frequency power source is connected to the RF antenna 105 through a matching box 106. Specifically, the RF power supplied from the RF power source 107 is supplied to plasma through the RF antenna 105.

In an upper portion of a sidewall of the tubular container 102, there is placed a gas supply pipe 108 through which raw material gases serving as raw materials for a film to be formed and an inert gas are supplied into the vacuum chamber 101. A gas supply amount controller configured to control the amounts of the raw material gases and the inert gas to be supplied is placed on the gas supply pipe 108. In this example, SiH₄ and H₂, or the like are supplied as the raw material gases, while Ar or the like is supplied as the inert gas. By supplying these gases, plasma of SiH₄, N₂ and Ar, or the like is generated in an upper portion of the inside of the vacuum chamber 101.

A substrate support table 110 configured to hold a substrate 109, or the film formation target, is placed in a lower portion of the inside of the tubular container 102. This substrate support table 110 is formed of a substrate holding portion 111 configured to hold the substrate 109, and a support shaft 112 configured to support this substrate holding portion 111. A heater 113 for heating is placed inside the substrate holding portion 111. The temperature of this heater 113 is adjusted by a heater control device 114. Accordingly, the temperature of the substrate 109 during plasma processing can be controlled at 300°C, for example.

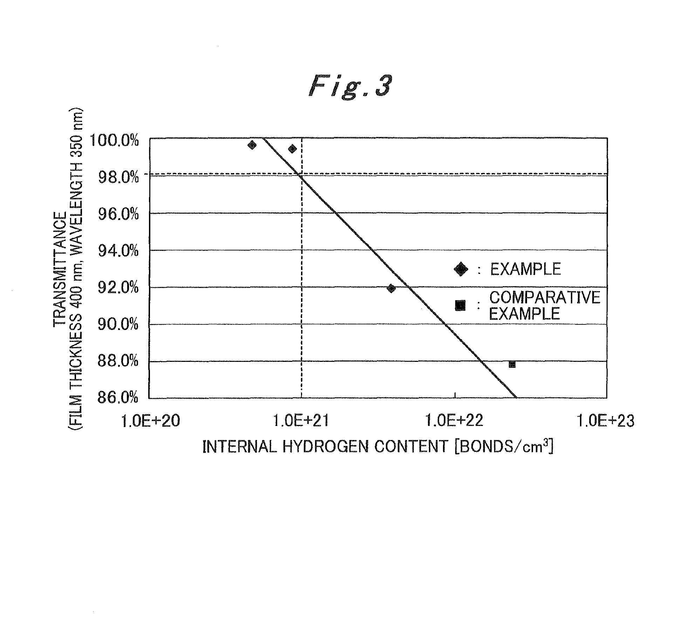

The support shaft 112 is provided with a vertical drive mechanism (unillustrated) so that the substrate 109 can be off a high-density plasma region as shown in Fig. 2, that is, the substrate 109 can be disposed at a position from which it does not receive an influence of high-density plasma. Specifically, the substrate holding portion 111 can be moved to any position within a distance range of 5 cm to 30 cm from the lower surface of the top panel 103. The substrate 109 is disposed, for example, at a position 10 or more cm away from the center of plasma generated. Such disposition makes it possible to form a SiN film having a small internal hydrogen content as shown in Fig. 3 mentioned later. Moreover, such a SiN film undergoes a plasma damage lower than those of SiN films formed by a general plasma CVD apparatus and has such superior characteristics that the withstand voltage is approximately 30% higher than those of the SiN films.

In addition, in the plasma CVD apparatus 100 described above, there is placed a master control device 119 capable of controlling each of the RF power, the pressure, the substrate temperature, the gas supply amounts, and the substrate position respectively through the RF power source 107, the vacuum device 104, the heater control device 114, the gas supply amount controller, and the vertical drive mechanism. Here, the dashed lines in Fig. 2 mean signal lines to transmit control signals from the master control device 119 to the RF power source 107, the vacuum device 104, the heater control device 114, and the gas supply amount controller, respectively.

The SiN film of this example can be formed in the plasma CVD apparatus 100 described above by controlling the RF power, the pressure, the film formation temperature, the gas supply amounts, and the substrate position through the master control device 119. Since the substrate 109 is disposed at a position away from the center of the plasma in the plasma CVD apparatus 100, though being a SiN film, the film can have film properties which allow as high transmittance as those of SiO films.

Now, the fact that the SiN film 21 in this example is a SiN film having as high transmittance as those of SiO films will be described with reference to a graph in Fig. 3. Note that a SiN film formed by a general plasma CVD apparatus is shown as a comparative example for comparison. Moreover, in this case, the film thickness was set to 400 nm which allows the minimum strength required for a protective film, and an evaluation was made by using a wavelength of 350 nm.

The hydrogen content inside each SiN film was checked through an IR analysis (infrared analysis, e.g. FTIR or the like). As shown in Fig. 3, there is a correlation between the number of Si-H bonds (found based on the peak area of Si-H bonds present around 2140 cm⁻¹) and the transmittance, and the smaller the number of Si-H bonds, the higher the transmittance of the film. Now, in the case of the SiN film formed by the general plasma CVD apparatus (comparative example), the number of Si-H bonds is 2.0×10²² [bonds/cm³] or larger and the transmittance is around 88% even under the best processing condition. In contrast, in the case of the SiN film 21 in this example, the number of Si-H bonds can be smaller than 2.0×10²² [bonds/cm³] and the transmittance can be high as well. Particularly, when the number of Si-H bonds is less than 1.0×10²¹ [bonds/cm³], a transmittance of 98% or higher can be achieved. This means that the hydrogen, i.e. impurities in the film is smaller in amount than the SiN film formed by the general plasma CVD apparatus. This further implies that an attenuation coefficient k of the film itself is 0.005 or lower, which is extremely low, thereby achieving high transmittance.

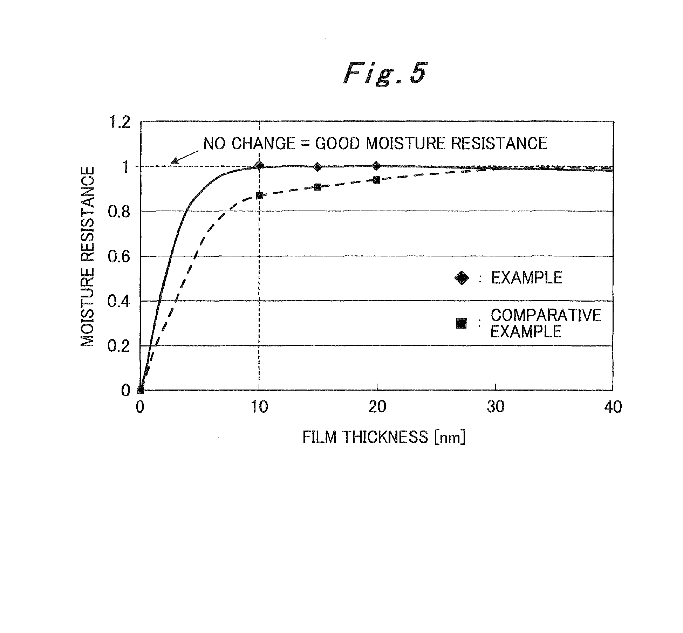

Moreover, the film thickness of the SiN film 21 is set to a film thickness with which the element can be physically protected, that is, a film thickness with which the semiconductor layers of the element can be prevented from being scratched. Specifically, the film thickness is set to 400 to 1000 nm which is used among general LEDs. When the film thickness is within this range, the SiN film 21 has sufficient moisture resistance as can be seen from Fig. 5 mentioned later, and further has such characteristics that the withstand voltage is high and also the transmittance is high as mentioned earlier.

Accordingly, in the element structure described above, since the SiN film 21 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. Moreover, since the withstand voltage of the film itself is high, there is no need for the SiN film 21 to have a large film thickness or to be etched as in the conventional case. Thereby, the film formation cost can be reduced.

Table 1 shows the migration prevention performance, the transmittance, the film formation cost, and the feasibility of a high-luminance structure in comparison with those of Conventional Examples 1 and 2 mentioned earlier. Note that Table 1 also shows Examples 2, 3, and 4 described later.

**[Table 1]**

| | Conventional Example 1 | Conventional Example 2 | Example 1 | Example 2 | Example 3 | Example 4 |
|---|---|---|---|---|---|---|
| Migration Prevention Performance | Poor | Excellent | Excellent | Good | Excellent | Excellent |
| Light Transmittance | Good | Poor | Good | Excellent | Excellent | Excellent |
| Film Thickness: 500 nm | 100% | 80 to 90% | 99.6% | 99.9% | 99.9% | 99.9% |
| Wavelength: 350 nm | (Note 1) | | | | | |
| Film Formation Cost | Poor | Relatively Poor | Good | Good | Good | Good |
| Feasibility of High-Luminance Structure | Relatively Poor | Relatively Poor | Good | Good | Excellent | Excellent |

| | | | | | | |
|---|---|---|---|---|---|---|
| (Note 1): 80 to 90% around the p-electrode due to the presence of the SiN film | | | | | | |

As shown in Table 1, since the SiN film 21 covers the whole element, the migration prevention performance in this example is higher than Conventional Example 1 and the same as Conventional Example 2. Thereby, the reliability of the element is improved.

Moreover, in comparisons under a condition that the film thickness and the wavelength of light are 500 nm and 350 nm, respectively, the transmittance in this example is 99.6% in terms of the transmittance of the whole protective film. This is higher than Conventional Example 2 and substantially the same as Conventional Example 1 (in a case of allowing for the transmittance around the p-electrode). Thereby, the light extraction efficiency is improved.

Furthermore, the film formation cost in this example is lower than Conventional Example 1 which requires an etching process and Conventional Example 2 in which the film thickness is large, because the protective film has higher withstand voltage than normal SiN films and the thickness of the whole protective film can be made small.

As described, this example can satisfy all of high migration prevention performance, high transmittance, and low film formation cost and therefore improves the feasibility of a high-luminance structure as compared to the conventional cases.

### (Example 2)

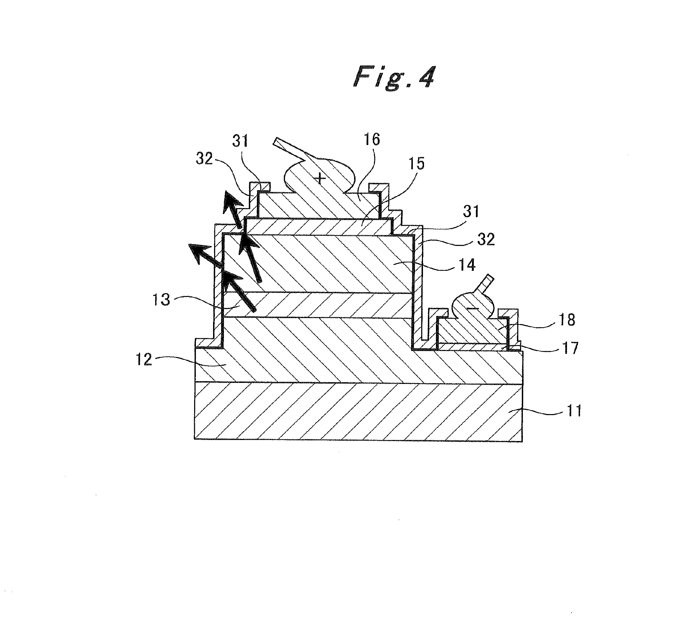

Fig. 4 is a cross-sectional view showing an LED element structure of this example. Note that in Fig. 4, the same components as the components described in Example 1 (see Fig. 1) are denoted by the same reference numerals, and overlapping description thereof is omitted. Moreover, the arrows in the drawing show how light is transmitted.

In the LED of this example, the element structure of the semiconductor layers has the same configuration as that of the LED described in Example 1 (see Fig. 1). Moreover, like Example 1, the protective film is formed in such a way as to cover the periphery of the semiconductor layers and the periphery of the electrode portions except for the openings on the p-pad 16 and the n-pad 18 for the bumps. However, the configuration of this protective film differs from that of Example 1.

Specifically, as the protective film, a SiN film 31 (first protective film) and a SiO film 32 (second protective film) are sequentially stacked. The SiN film 31 is made of a SiN having insulating properties and high transmittance. The SiO film 32 is made of a SiO having insulating properties. In other words, formed is a protective film of a two-layer structure having the SiN film 31 as the first layer and the SiO film 32 as the second layer. Accordingly, the structure is such that the two-layer structure with the SiN film 31 and the SiO film 32 protects not only the periphery of the p-electrode 15 containing Ag but also the periphery of the whole element.

Of the SiN film 31 and the SiO film 32, the SiN film 31 is formed by the plasma CVD apparatus shown in Fig. 2. On the other hand, for the SiO film 32, the plasma CVD apparatus shown in Fig. 2 can be used but a normal plasma CVD method (apparatus) may be used instead. In particular, a plasma CVD method (apparatus) using high-density plasma is preferable. Note that it is possible to use some other method such for example as a sputtering method (apparatus) or a vacuum deposition method (apparatus) as long as a similar SiO film can be formed.

As mentioned earlier, SiN protective films normally have a problem that they have high moisture resistance but have low transmittance and poor withstand voltage.

In this respect, in this example, the SiN film 31 is formed to have high transmittance as described in Fig. 3 and also to have a film thickness with which the SiN film 31 can maintain its moisture resistance. Further, the structure is such that the SiO film 32 having poor moisture resistance but having high transmittance and high withstand voltage is stacked on the outer side of this SiN film 31.

Now, the relationship between the moisture resistance and the film thickness of the SiN film 31 will be described with reference to a graph in Fig. 5. Fig. 5 additionally shows a graph of the moisture resistance and the film thickness of a SiN film formed by a general plasma CVD apparatus with a dotted line as a comparative example. Note that the moisture resistance in Fig. 5 refers to the moisture resistance of an evaluation target SiN film evaluated by sequentially forming the evaluation target SiN film and a SiO film, which has a large internal moisture content, on a cobalt-iron film as a sample and then measuring the magnetization decay of the cobalt and iron in the formed sample.

As shown in the graph in Fig. 5, in the comparative example, the moisture resistance drops as the film thickness becomes smaller when the film thickness of the SiN film is smaller than 35 nm, while the moisture resistance is good when the film thickness of the SiN film is 35 nm or larger. In contrast, in this example, the moisture resistance drops as the film thickness becomes smaller when the film thickness of the SiN film is smaller than 10 nm, while the moisture resistance is good when the film thickness of the SiN film is 10 nm or larger. As described, while the comparative example can achieve good moisture resistance only when the film thickness of the SiN film is 35 nm or larger, this example can achieve good moisture resistance when the film thickness of the SiN film 31 is 10 nm or larger. In other words, 10 nm or larger is a film thickness with which the SiN film 31 can maintain its moisture resistance.

Moreover, the SiO film 32 is such that the total film thickness of itself and the SiN film 31 is set to a film thickness with which the element can be physically protected, that is, a film thickness with which the semiconductor layers of the element can be prevented from being scratched. Specifically, the total film thickness is set to 400 to 1000 nm which is used among general LEDs.

In the element structure described above, since the SiN film 31 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. Moreover, since there is no need for the SiN film 31 to have a large film thickness or to be etched, the film formation cost can be reduced.

In addition, as shown in Table 1, since the SiN film 31 covers the whole element, the migration prevention performance in this example is higher than that in Conventional Example 1. Thereby, the reliability of the element is improved.

Moreover, in comparisons under a condition that the film thickness and the wavelength of light are 500 nm and 350 nm, respectively (the film thickness and the transmittance of the SiN film 31 of this example are 35 nm and 99.9%, respectively), the transmittance in this example is 99.9% in terms of the transmittance of the whole protective film. This is higher than Conventional Example 2 and substantially the same as Conventional Example 1 (in a case of allowing for the transmittance around the p-electrode) and furthermore higher than Example 1. Thereby, the light extraction efficiency is improved.

Furthermore, the film formation cost in this example is lower than Conventional Example 1 which requires an etching process and Conventional Example 2 in which the film thickness is large and is the same as Example 1, because the protective film can have high withstand voltage due to the stacking of the SiO film 32 and the thickness of the whole protective film can be made small.

As described, this example can satisfy all of high migration prevention performance, high transmittance, and low film formation cost and therefore improves the feasibility of a high-luminance structure as compared to the conventional cases.

### (Example 3)

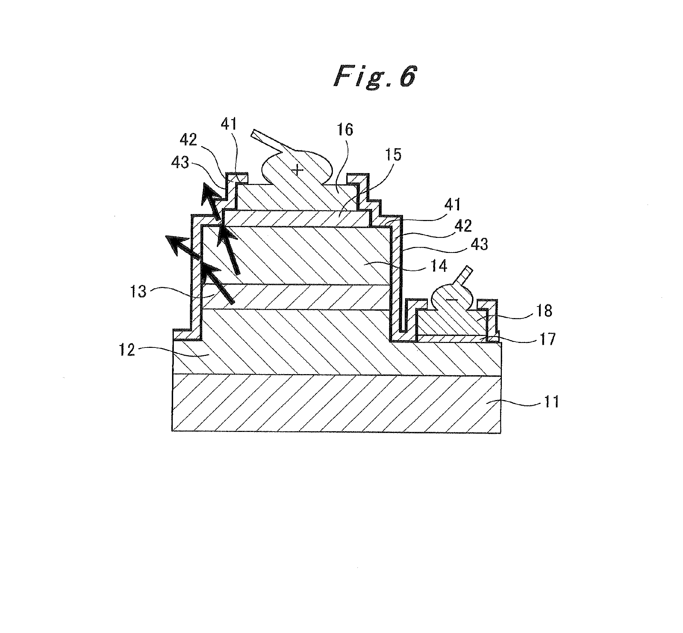

Fig. 6 is a cross-sectional view showing an LED element structure of this example. Note that in Fig. 6, the same components as the components described in Example 1 (see Fig. 1) are denoted by the same reference numerals, and overlapping description thereof is omitted. Moreover, the arrows in the drawing show how light is transmitted.

In the LED of this example, the element structure of the semiconductor layers has the same configuration as that of the LED described in Example 1 (see Fig. 1). Moreover, like Example 1, the protective film is formed in such a way as to cover the periphery of the semiconductor layers and the periphery of the electrode portions except for the openings on the p-pad 16 and the n-pad 18 for the bumps. However, the configuration of this protective film differs from those of Examples 1 and 2.

Specifically, as the protective film, a SiN film 41 (first protective film), a SiO film 42 (second protective film), and a SiN film 43 (third protective film) are sequentially stacked. The SiN film 41 is made of a SiN having insulating properties and high transmittance. The SiO film 42 is made of a SiO having insulating properties. The SiN film 43 is made of a SiN having insulating properties and high transmittance. In other words, formed is a protective film of a three-layer structure having the SiN film 41 as the first layer, the SiO film 42 as the second layer, and the SiN film 43 as the third layer. Accordingly, the structure is such that the three-layer structure with the SiN film 41, the SiO film 42, and the SiN film 43 protects not only the periphery of the p-electrode 15 containing Ag but also the periphery of the whole element.

Of the SiN film 41, the SiO film 42, and the SiN film 43, the SiN films 41 and 43 are formed by the plasma CVD apparatus shown in Fig. 2. On the other hand, for the SiO film 42, the plasma CVD apparatus shown in Fig. 2 can be used but a normal plasma CVD method (apparatus) may be used instead. In particular, a plasma CVD method (apparatus) using high-density plasma is preferable. Note that it is possible to use some other method such for example as a sputtering method (apparatus) or a vacuum deposition method (apparatus) as long as a similar SiO film can be formed.

As mentioned earlier, SiN protective films normally have a problem that they have high moisture resistance but have low transmittance and poor withstand voltage. Moreover, SiO protective films have such a nature that moisture easily passes therethrough and further is easily held therein. Thus, once such a film holds a large amount of moisture, the film becomes a source of moisture. This leads to a problem that even when a SiN protective film is formed on the inner side of the film, moisture permeates the SiN protective film and enters the element side, though only slightly, if the film thickness of the SiN protective film is small.

In this respect, in this example, the SiN film 41 is formed to have high transmittance as described in Fig. 3 and also to have a film thickness of 10 nm or larger with which the SiN film 41 can maintain its moisture resistance as described in Fig. 5. Further, the structure is such that the SiO film 42 having poor moisture resistance but having high transmittance and high withstand voltage is stacked on the outer side of this SiN film 41, and further the SiN film 43 having high transmittance and a film thickness of 10 nm or larger with which the SiN film 43 can maintain its moisture resistance is stacked on the outer side of the SiO film 42.

Moreover, the SiO film 42 is such that the total film thickness of itself, the SiN film 41, and the SiN film 43 is set to a film thickness with which the element can be physically protected, that is, a film thickness with which the semiconductor layers of the element can be prevented from being scratched. Specifically, the total film thickness is set to 400 to 1000 nm which is used among general LEDs.

In the element structure described above, since the SiN film 41 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. Furthermore, in this example, since the SiN film 43 is further provided on the outer side of the SiO film 42, moisture entering the inside of the protective film, or the inside of the SiO film 42 in particular, can be reduced. Accordingly, moisture entering the element side can be reduced. As a result, the migration prevention performance can be improved further as compared to Examples 1 and 2. Moreover, since there is no need for the SiN films 41 and 43 to have a large film thickness or to be etched as in the conventional case, the film formation cost can be reduced.

In addition, as shown in Table 1, the migration prevention performance in this example is higher than that in Conventional Example 1 and also higher than that in Conventional Example 2. Thereby, the reliability of the element is further improved.

Moreover, in comparisons under a condition that the film thickness and the wavelength of light are 500 nm and 350 nm, respectively (the film thickness and the transmittance of each of the SiN films 41 and 43 of this example are 35 nm and 99.9%, respectively), the transmittance in this example is 99.9% in terms of the transmittance of the whole protective film. This transmittance is higher than Conventional Example 2 and substantially the same as Conventional Example 1 (in a case of allowing for the transmittance around the p-electrode), and furthermore higher than Example 1 and the same as Example 2. Thereby, the light extraction efficiency is improved. Like Example 2, this is because each of the SiN films 41 and 43 having low transmittance has a small film thickness relative to the film thickness of the whole protective film while the SiO film 42 having high transmittance has a large film thickness, and therefore the protective film can achieve high transmittance as a whole.

Furthermore, the film formation cost in this example is slightly higher than that in Example 2 because the SiN film 43 is additionally stacked. However, the film formation cost in this example is lower than that in Conventional Example 1 which requires an etching process and that in Conventional Example 2 in which the film thickness is large, because the protective film can have high withstand voltage as a whole due to the stacking of the SiO film 42 and the thickness of the whole protective film can be made small.

As described, this example can satisfy all of high migration prevention performance, high transmittance, and low film formation cost and therefore improves the feasibility of a high-luminance structure as compared to the conventional cases.

### (Example 4)

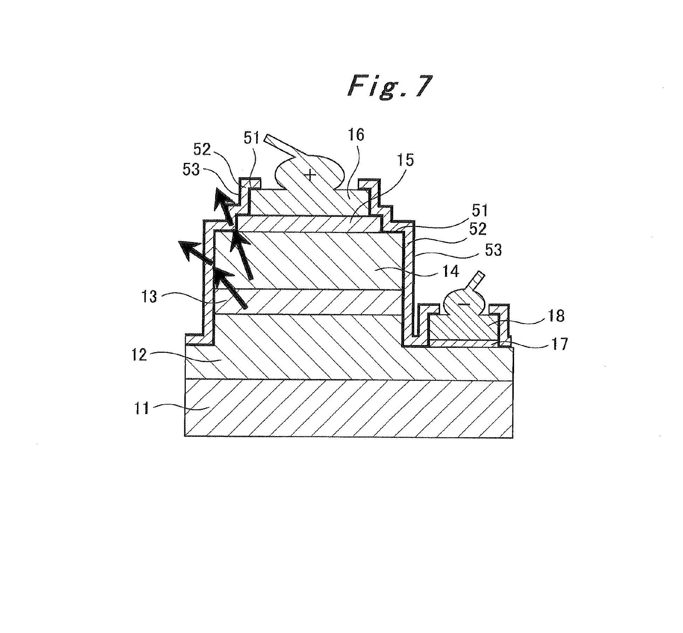

Fig. 7 is a cross-sectional view showing an LED element structure of this example. Note that in Fig. 7, the same components as the components described in Example 1 (see Fig. 1) are denoted by the same reference numerals, and overlapping description thereof is omitted. Moreover, the arrows in the drawing show how light is transmitted.

In the LED of this example, the element structure of the semiconductor layers has the same configuration as that of the LED described in Example 1 (see Fig. 1). Moreover, like Example 1, the protective film is formed in such a way as to cover the periphery of the semiconductor layers and the periphery of the electrode portions except for the openings on the p-pad 16 and the n-pad 18 for the bumps. However, the configuration of this protective film differs from those of Examples 1 and 2. Further, the protective film differs from that of Example 3 in the film properties of the SiO film.

Specifically, as the protective film, a SiN film 51 (first protective film), a SiO film 52 (second protective film), and a SiN film 53 (third protective film) are sequentially stacked. The SiN film 51 is made of a SiN having insulating properties and high transmittance. The SiO film 52 is made of a SiO having insulating properties and a small internal moisture content. The SiN film 53 is made of a SiN having insulating properties and high transmittance. In other words, formed is a protective film of a three-layer structure having the SiN film 51 as the first layer, the SiO film 52 as the second layer, and the SiN film 53 as the third layer. Accordingly, the structure is such that the three-layer structure with the SiN film 51, the SiO film 52, and the SiN film 53 protects not only the periphery of the p-electrode 15 containing Ag but also the periphery of the whole element.

Of the SiN film 51, the SiO film 52, and the SiN film 53, the SiN films 51 and 53 are formed by the plasma CVD apparatus shown in Fig. 2. On the other hand, the SiO film 52 is formed by a normal plasma CVD method (apparatus). In particular, a plasma CVD method (apparatus) using high-density plasma, for example, the plasma CVD apparatus shown in Fig. 2 is preferable. Note that it is possible to use some other method such for example as a sputtering method (apparatus) or a vacuum deposition method (apparatus) as long as a similar SiO film can be formed.

As mentioned earlier, SiN protective films normally have a problem that they have high moisture resistance but have low transmittance and poor withstand voltage. Moreover, SiO protective films have such a nature that moisture easily passes therethrough and further is easily held therein. Thus, once such a film holds a large amount of moisture, the film becomes a source of moisture. This leads to a problem that even when a SiN protective film is formed on the inner side of the film, moisture permeates the SiN protective film and enters the semiconductor-layer side, though only slightly, if the film thickness of the SiN protective film is small.

In this respect, in this example, a SiO film having a small internal moisture content is used as the SiO film 52 in the three-layer structure formed of the SiN film 51, the SiO film 52, and the SiN film 53. Specifically, the SiO film should have film properties which make the number of Si-OH bonds thereof (found based on the peak area of Si-OH bonds present around 3738 cm⁻¹) equal to or lower than 1.3×10²¹ [bonds/cm³] in a measurement using an IR analysis. If so, the moisture content in the film should also show a sufficiently low value in a measurement using thermal desorption spectroscopy (TDS). Table 2 given below shows comparisons between the normal SiO film used in each of Examples 2 and 3 and the SiO film with a low moisture content used in this example. While the number of Si-OH bonds and moisture content of the normal SiO film are 2.6×10²¹ [bonds/cm³] and 2.6×10²¹ [molecules/cm³], respectively, those of the low-moisture SiO film of this example are both 1/2 of the above value.

**[Table 2]**

| | Normal SiO Film | Low-Moisture SiO Film |
|---|---|---|
| Moisture Content (TDS) [molecules/cm³] | 2.6×10²¹ | 1.3×10²¹ |
| Number of Si-OH Bonds (IR) [bonds/cm³] | 2.6×10²¹ | 1.3×10²¹ |

In Example 3, since the SiN film 43 is provided in the third layer, moisture hardly enters the SiO film 42 from the outside. However, since the SiO film 42 naturally contains a large amount of moisture, the SiN film 41 in the first layer for preventing the diffusion of moisture from the SiO film 42 to the element side cannot have a small film thickness. In contrast, since the internal moisture content of the SiO film of this example is 1/2 of that of the normal SiO film as shown in Table 2, the SiN film 51 for preventing the diffusion of moisture to the element side can be made thin. Specifically, 10 nm, which is the minimum film thickness with which the SiN film 51 can maintain its moisture resistance as described in Fig. 2, can be reduced by 1/2 to 5 nm. Accordingly, higher transmittance than Example 3 can be achieved.

Moreover, this example too has a three-layer structure in which the SiO film 52 having high transmittance and high withstand voltage is stacked on the outer side of the SiN film 51, and further the SiN film 53 is stacked on the outer side of the SiO film 52. However, the SiN film 51 is formed to have high transmittance as described in Fig. 3, and also to have a film thickness of 5 nm or larger as described above due to the small internal moisture content of the SiO film 52. Further, the structure is such that the SiN film 53 having high transmittance and a film thickness of 10 nm or larger with which the SiN film 53 can maintain its moisture resistance is stacked on the outer side of the SiO film 52.

Furthermore, the total film thickness of the SiN film 51, the SiO film 52, and the SiN film 53 is set to a film thickness with which the element can be physically protected, that is, a film thickness with which the semiconductor layers of the element can be prevented from being scratched. Specifically, the total film thickness is set to 400 to 1000 nm which is used among general LEDs.

In the element structure described above, since the SiN film 51 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. In this example, the film thickness of the SiN film 51 is smaller than that of the SiN film 41 of Example 3 but the internal moisture of the SiO film 52 itself is small in amount as mentioned above. Thereby, sufficiently high migration prevention performance can be achieved. Further, in this example, since the internal moisture content of the SiO film 52 is low, and the SiN film 53 is further provided on the outer side thereof, moisture entering the inside of the protective film, or the inside of the SiO film 52 in particular, can be reduced. Accordingly, moisture entering the element side can be reduced. As a result, the migration prevention performance can be improved further as compared to Example 2. Moreover, since there is no need for the SiN films 51 and 53 to have a large film thickness or to be etched, the film formation cost can be reduced.

In addition, as shown in Table 1, the migration prevention performance in this example is higher than that in Conventional Example 1 and also higher than that in Example 2. Thereby, the reliability of the element is further improved.

Moreover, in comparisons under a condition that the film thickness is 500 nm and the wavelength of light are 500 nm and 350 nm, respectively (the film thickness and the transmittance of each of the SiN films 51 and 53 of this example are 35 nm and 99.9%, respectively), the transmittance in this example is 99.9% in terms of the transmittance of the whole protective film. This transmittance is higher than Conventional Example 2 and substantially the same as Conventional Example 1 (in a case of allowing for the transmittance around the p-electrode), and furthermore higher than Example 1 and the same as Examples 2 and 3. Thereby, the light extraction efficiency is improved. Like Examples 2 and 3, this is because each of the SiN films 51 and 53 having low transmittance has a small film thickness relative to the film thickness of the whole protective film while the SiO film 52 having high transmittance has a large film thickness, and therefore the protective film can achieve high transmittance as a whole.

Furthermore, the film formation cost in this example is slightly higher than that in Example 2 because the SiN film 53 is additionally stacked. However, the film formation cost in this example is slightly lower that in than Example 3 because the SiN film 51 has a small film thickness. Also, the film formation cost in this example is lower than that in Conventional Example 1 which requires an etching process and that in Conventional Example 2 in which the film thickness is large, because the protective film can have high withstand voltage as a whole due to the stacking of the SiO film 52 and the thickness of the whole protective film can be made small.

As described, this example can satisfy all of high migration prevention performance, high transmittance, and low film formation cost and therefore improves the feasibility of a high-luminance structure as compared to the conventional cases.

Note that the materials and configurations of the semiconductor layers of the LEDs in Examples 1 to 4 described above are not limited to the materials and the configurations described above, and may be different materials and configurations. For example, each semiconductor layer may be made of a nitride semiconductor composed of a group III element such as In, Al, or Ga, and a group V element such as N, or the like. Moreover, the structure of the active layer 13 is not limited to a multiple quantum well structure and may be a single quantum well structure, a strained quantum well structure, or the like. Moreover, the substrate 11 is not limited to a sapphire substrate and may be a GaN substrate or the like. Moreover, for the method for fabricating each semiconductor layer, it is possible to use a publically known fabrication method such for example as a metal organic vapor phase epitaxy (MOVPE) method or a metal organic chemical vapor deposition (MOCVD) method.

Furthermore, while the p-electrode 15 has a multilayer structure, the p-electrode 15 may be configured to contain metals other than Ni and Pt as long as the p-electrode 15 contains a metal such as Ag or Cu that has a possibility of migration. Moreover, for its fabrication method, it is possible to use a publically known fabrication method such for example as a sputtering method or a vacuum deposition method. Stacked layers are formed into a desired pattern by a lift-off method, for example. Conventionally, in consideration of the migration of Ag or the like, a multilayer structure has been employed in which the layers above and below the Ag layer or the like layer are formed from different metals (sandwich structure). However, since the whole element is covered with any one of the protective films of Examples 1 to 4 described above, such a sandwich structure does not necessarily have be to employed in order to sufficiently suppress the migration of Ag or the like.

Moreover, each of the p-pad 16, the n-electrode 17, and the n-pad 18 has a single-layer structure or a multilayer structure. For their fabrication methods, it is possible to use a publically known fabrication method such for example as a sputtering method or a vacuum deposition method. A stacked layer(s) is(are) formed into a desired pattern by a lift-off method, for example, as in the case of the p-electrode 15.

Note that the silicon nitride, as represented by Si₃N₄, could be described as SiₓN_{y} based on its composition ratio, but is described above as SiN for the sake of simple description. Likewise, the silicon oxide, as represented by SiO₂, could be described as SiₓO_{y} based on its composition ratio, but is described above as SiO for the sake of simple description.

### INDUSTRIAL APPLICABILITY

The present invention is designed to be applied to semiconductor light-emitting elements and is preferably applied to white LEDs in particular.

## Claims

1. A protective film for protecting a semiconductor light-emitting element including a plurality of semiconductor layers formed on a substrate and a plurality of electrode portions serving as electrodes of the plurality of semiconductor layers, comprising:
a first protective film covering a periphery of the plurality of semiconductor layers and a periphery of the plurality of electrode portions as the protective film, wherein
the first protective film is made of a silicon nitride whose number of Si-H bonds inside the film is below 1.0×10²¹ [bonds/cm³].

2. The protective film of a semiconductor light-emitting element according to claim 1, further comprising:
a second protective film covering a periphery of the first protective film, wherein
the first protective film has a film thickness of 10 nm or larger,
and the second protective film is made of a silicon oxide.

3. The protective film of a semiconductor light-emitting element according to claim 2, further comprising:
a third protective film covering a periphery of the second protective film, wherein
the third protective film is made of a silicon nitride, whose number of Si-H bonds inside the film is below 1.0×10²¹ [bonds/cm³], and has a film thickness of 10 nm or larger as in a case of the first protective film.

4. The protective film of a semiconductor light-emitting element according to claim 3, wherein the second protective film is made of a silicon oxide whose number of Si-OH bonds inside the film is 1.3×10²¹ [bonds/cm³] or smaller, in which case the film thickness of the first protective film is set to 5 nm or larger.

5. The protective film of a semiconductor light-emitting element according to any one of claims 1 to 4, wherein at least one of the plurality of electrode portions is made of a metal containing silver.

6. A semiconductor light-emitting element using the protective film of a semiconductor light-emitting element according to any one of claims 1 to 5.

7. A method for fabricating a protective film for protecting a semiconductor light-emitting element including a plurality of semiconductor layers formed on a substrate and a plurality of electrode portions serving as electrodes of the plurality of semiconductor layers, comprising:
providing a first protective film covering a periphery of the plurality of semiconductor layers and a periphery of the plurality of electrode portions as the protective film, the first protective film being formed from a silicon nitride whose number of Si-H bonds inside the film is below 1.0×10²¹ [bonds/cm³].

8. The method for fabricating a protective film of a semiconductor light-emitting element according to claim 7, wherein a film thickness of the first protective film is set to 10 nm or larger,
the method further comprises providing a second protective film covering a periphery of the first protective film, the second protective film being formed from a silicon oxide.

9. The method for fabricating a protective film of a semiconductor light-emitting element according to claim 8, further comprising:
providing a third protective film covering a periphery of the second protective film, the third protective film being formed from a silicon nitride, whose number of Si-H bonds inside the film is below 1.0×10²¹ [bonds/cm³], to a film thickness of 10 nm or larger as in a case of the first protective film.

10. The method for fabricating a protective film of a semiconductor light-emitting element according to claim 9, wherein the second protective film is formed from a silicon oxide whose number of Si-OH bonds inside the film is 1.3×10²¹ [bonds/cm³] or smaller, in which case the film thickness of the first protective film is set to 5 nm or larger.

11. The method for fabricating a protective film of a semiconductor light-emitting element according to any one of claims 7 to 10, wherein at least one of the plurality of electrode portions is made of a metal containing silver.
